# FASCICULE DE BREVET EUROPEEN

(11) **EP 3 595 832 B1**
(45) Date de publication et mention de la délivrance du brevet: **17.07.2024**
(21) Numéro de dépôt: 18714314.4
(22) Date de dépôt: 14.03.2018
(51) Int. Cl.: B22F 3/22, B22F 3/11, B22F 7/00, B22F 3/105

(54) **MATÉRIAU MÉTALLIQUE FRITTÉ À POROSITÉ ORIENTÉE COMPRENANT AU MOINS UNE PARTIE FERROMAGNÉTIQUE ET PROCÉDÉ DE FABRICATION**
GESINTERTES METALLMATERIAL MIT GERICHTETER POROSITÄT UND MINDESTENS EINEM FERROMAGNETISCHEN TEIL SOWIE HERSTELLUNGSVERFAHREN DAFÜR
SINTERED METAL MATERIAL HAVING DIRECTIONAL POROSITY AND COMPRISING AT LEAST ONE FERROMAGNETIC PART, AND PRODUCTION METHOD THEREOF

(30) Priorité: 16.03.2017 FR 1752137
(43) Date de publication de la demande: 22.01.2020
(73) Titulaire: Office National d'Etudes et de Recherches Aérospatiales, 91120 Palaiseau (FR)
(72) Inventeur: LAMBERT, Océane, 92120 Montrouge (FR); DAVOINE, Cécile, 92160 Antony (FR)
(74) Mandataire: IPAZ
(86) Numéro de dépôt international: PCT/FR2018/050615
(87) Numéro de publication internationale: WO 2018/167430

(56) Documents cités:
- CN-A- 104 387 768
- JP-A- 2006 052 451
- JP-A- H0 436 409
- JP-A- H05 271 716
- PORTER MICHAEL M. ET AL: "Magnetic freeze casting inspired by nature", MATERIALS SCIENCE AND ENGINEERING: A, vol. 556, 1 October 2012 (2012-10-01), AMSTERDAM, NL, pages 741 - 750, XP055817980, ISSN: 0921-5093, DOI: 10.1016/j.msea.2012.07.058
- PLUNK AMELIA A ET AL: "Iron foams created by directional freeze casting of iron oxide, reduction and sintering", MATERIALS LETTERS, ELSEVIER, AMSTERDAM, NL, vol. 191, 29 December 2016 (2016-12-29), pages 112 - 115, XP029902065, ISSN: 0167-577X, DOI: 10.1016/J.MATLET.2016.12.104
- ANDRÉ RÖTHLISBERGER ET AL: "Abstract", JOURNAL OF MATERIALS RESEARCH, vol. 31, no. 06, 1 March 2016 (2016-03-01), US, pages 753 - 764, XP055478379, ISSN: 0884-2914, DOI: 10.1557/jmr.2016.62
- TANG YUFEI ET AL: "Fabrication of lamellar porous alumina with axisymmetric structure by directional solidification with applied electric and magnetic fields", JOURNAL OF THE EUROPEAN CERAMIC SOCIETY, vol. 36, no. 5, 22 December 2015 (2015-12-22), pages 1233 - 1240, XP029387680, ISSN: 0955-2219, DOI: 10.1016/J.JEURCERAMSOC.2015.12.012
- MICHAEL M. PORTER ET AL: "Microstructural Control of Colloidal-Based Ceramics by Directional Solidification Under Weak Magnetic Fields", JOURNAL OF THE AMERICAN CERAMIC SOCIETY., vol. 99, no. 6, 1 June 2016 (2016-06-01), US, pages 1917 - 1926, XP055478164, ISSN: 0002-7820, DOI: 10.1111/jace.14183

## Description

L'invention concerne les matériaux frittés à porosité orientée par champ magnétique et leur fabrication. Les porosités sont orientées, fines de l'ordre de la dizaine de microns et débouchantes.

Il existe plusieurs procédés d'élaboration de matériaux à porosité orientée :
- Une première technique consiste à créer un matériau composite dont l'une des phases sera retirée par décomposition ou par évaporation, décrit par l'article de D.C. Dunand dans Advanced Engineering Materials 6 (6) (2004).

Jorgensen et al propose dans Acta Materalia 59 (2011) 640-50 de densifier des fils d'acier avec de la poudre ou des feuilles de titane, puis de retirer l'acier de façon électrochimique. La taille des pores est alors déterminée par le diamètre des fils. Ce procédé ne permet pas des porosités très fines. De plus les matériaux obtenus présentent des parois poreuses et irrégulières et l'architecture est difficilement contrôlée.
- Une deuxième technique consiste à fritter de la poudre sous pression de gaz pour créer des bulles dans le matériau qui seront ensuite orientées par un traitement thermomécanique de la pièce. Kearns et al ont ainsi étudié dans International journal of powdermetallurgy24 (1) (1988) 59-64la fabrication de pièces poreuses de titane par compression isostatique à chaud de poudre métallique en présence d'argon, la densification complète étant empêchée par la présence du gaz. Puis un traitement thermique de la pièce à haute température pendant plusieurs jours permet l'expansion des bulles de gaz par fluage de la matière autour d'elles. Afin d'orienter les pores, la pièce peut être laminée ou extrudée. Davis et al (Journal of Materials Research 16 (5) (2001) 1508-19) ont fusionné ces deux dernières étapes en réalisant un cyclage thermique sous contrainte mécanique unidirectionnelle sur les alliages superplastiques. Ces procédés permettent d'obtenir des porosités importantes, jusqu'à 40 % dans certaines conditions, mais demandent un équipement très coûteux ainsi que de nombreuses étapes, dont le traitement thermique qui peut être très long. De plus, on n'obtient une forte densité de porosités ouvertes que pour des alliages superplastiques, et dans ce cas le plus favorable, le rapport d'aspect des pores est de 2en moyenne. L'orientation préférentielle des pores n'est donc pas très marquée. Afin de simplifier ce procédé et d'assurer une forte orientation des pores, D. Spoerke et al (Journal of Biomedical Materials Research Part A 84 (2) (2008) 102-418) proposent de remplacer la poudre par des fils de titane. Même si des rapports d'aspect de pore allant jusqu'à 25 sont obtenus, la porosité totale n'excède pas 13 % dont des porosités ouvertes n'excédant pas 10 %.
- Enfin, les matériaux dénommés *gasar* ou *lotus* selon CN104593630 ou Nakajima H., Material Science 52 (2007) 1091-1173 présentent des porosités cylindriques créées par la différence de solubilité d'un gaz dans un métal en phase liquide et solide. Le métal fondu est saturé en gaz puis solidifié de façon directionnelle. Le gaz est alors rejeté au front de solidification en créant des porosités dans la direction perpendiculaire au front. Cette méthode est cependant très délicate à mettre en œuvre, de nombreux paramètres étant à optimiser, notamment la nature et la pression de gaz, la vitesse de solidification, etc.,) menant à des porosités de taille assez importante, de l'ordre de quelques centaines de microns à quelques millimètres.
- M. Porter et al. proposent dans J.Am.Ceram.Soc. 99 (2016) 1917-1926 de fabriquer des matériaux poreux composites zircone/magnétite par une technique de freeze-casting classique sous l'action d'un champ magnétique. Ici aussi la structure interne du matériau poreux est gouvernée par la solidification dirigée du solvant. En effet, les particules magnétiques en suspension sont suffisamment fines pour que la gravité soit négligeable et que la dispersion des particules soit due aux forces interparticulaires (Van derWaals, électrostatiques, stériques). Les particules magnétiques s'agglutinent dans les zones de plus forte densité de flux magnétique et créent des inhomogénéités dans le matériau final, mais ne se répartissent pas uniformément dans la solution et ne participent finalement pas à l'architecture globale de la pièce. De plus, dans ce procédé, la structure du matériau poreux obtenu est intrinsèquement liée à la solidification dirigée du solvant, ce qui mène à plusieurs difficultés :
   - Si les poudres sont trop fines elles peuvent ne pas être rejetées dans l'espace inter-dendritique, mais être incluses dans les dendrites et donc entraver les pores de la pièce finale ;
   - Les premiers grains de glace au contact avec la plaque réfrigérante sont équiaxes, ce qui crée à la fin du procédé une couche plus dense qui limite la perméabilité globale de la pièce. Cette couche est difficile à retirer a posteriori car la découpe d'un matériau poreux par des techniques classiques bouche les pores et peut créer une couche dense à la surface ;
   - Au fur et à mesure que les dendrites de glace se forment, le gradient thermique vu par le solvant liquide diminue car la glace est isolante, on a donc des grains qui vont être de plus en plus grands. Il y a donc une inhomogénéité de la porosité dans l'épaisseur de la pièce ;
   - Ce procédé est très dépendant du solvant utilisé. En effet, chaque solvant cristallise d'une certaine façon. Pour chaque solvant, il faut donc refaire une étude paramétrique pour obtenir les propriétés voulues.

Dans le domaine des céramiques, la technique dite de « freeze-casting » soit littéralement « coulée gelée » décrite par S. Deville dans Acta Materalia55 (2007) 1965-74 permet d'obtenir des matériaux céramiques à porosités orientées en quelques étapes :
1. Un mélange de poudres nanométriques et de solvant est préparé.
2. Le mélange est placé sur une plaque réfrigérante afin de solidifier de façon directionnelle le solvant en formant des dendrites dans la direction du front de solidification.
3. Le solvant est ensuite sublimé sous vide, en passant sous son point triple : la pièce à vert obtenue présente des porosités orientées qui reproduisent la forme des anciennes dendrites.
4. Le matériau est enfin fritté à haute température pour obtenir la pièce finale.

Le matériau ainsi obtenu présente des microporosités orientées à partir d'une certaine épaisseur. Les premiers cristaux d'eau sont équiaxes, puis les dendrites commencent à se former et deviennent homogènes en dimension et en direction à partir 60 µm d'épaisseur.

La Demanderesse a découvert que l'application de ce procédé tel que décrit dans l'article ci-dessus avec des poudres métalliques dans une solution aqueuse pour obtenir des porosités orientées de l'ordre de la dizaine de microns n'est guère possible. En effet, les poudres métalliques sont plus denses et plus grosses que les poudres céramiques, (car ces dernières peuvent être broyées très finement), la Demanderesse ayant observé une sédimentation avant la solidification de l'eau. Les dendrites n'arrivent donc pas à repousser la poudre dans l'espace inter-dendritique et les porosités finales ne sont pas orientées. Si on augmente la viscosité du solvant, le matériau obtenu peut être très poreux mais n'est pas orienté car les dendrites ne réussissent pas à se développer au sein du réseau tridimensionnel créé par le liant. On obtient un matériau poreux à porosité non orientée.

C'est pourquoi, dans la littérature, très peu de cas de freeze-casting métallique sont recensés. Le procédé tel quel n'a pu être appliqué que sur des poudres de titane fines et donc légères que ce soit en solution aqueuse par J.C. Li et al, Acta Materalia59 (2011) 146-58 ; Chino Y. et al, Acta Materalia56 (2008) 105-13 ; ou avec du camphène comme solvant par S-W Yook et al, Materials Letters 63 (2009) 1502-4.
- M. Fukushima et al dans Materials Letters153 (2015) 99-101, ont pu contourner le problème de la sédimentation en ajoutant un gélifiant dans la solution aqueuse. Une première étape consiste à refroidir le mélange en-dessous de la température de gélification afin d'obtenir une dispersion homogène de la poudre dans un milieu très visqueux où il n'y a pas de sédimentation, puis à solidifier l'eau de façon directionnelle. Ce procédé est cependant très délicat à mettre en œuvre car le réseau tridimensionnel créé par le gel entrave la croissance des dendrites et peut donc facilement donner lieu à une structure non orientée. De plus, il faut utiliser une poudre extrêmement fine environ 400nm, et donc coûteuse, pour qu'elle puisse être repoussée efficacement dans l'espace inter-dendritique. Ces poudres de dimensions inférieures à 1 µm présentent de plus des risques toxicologiques accrus.
- Récemment, les techniques pour obtenir des pièces en cuivre (A.I. Cuba Ramos et al, MaterialsLetters153 (2015) 99-101 ou en nickel (H. Jo et al, Metallurgical and MaterialsTransactionsE3E (2016) 46-54 par *freeze-casting* à partir de poudres d'oxyde ont été développés. L'inconvénient de cette technique est le fort retrait lors du frittage dû à la réduction de l'oxyde qui entraîne l'apparition de fissures, ainsi que l'hétérogénéité en taille, en forme et en orientation des pores dus à la difficulté de réussite de l'étape de congélation unidirectionnelle. M. Porter et al. divulgue dans Materials Sciences and Engineering A, Vol. 556, p 741-750, (2012), un procédé pour l'élaboration de composite céramique ferromagnétique par la méthode de "magnetic freeze casting" dans lequel la direction du champ magnétique est modulée perpendiculairement selon la direction de la gravité.

Les procédés ci-dessus, selon les observations faites par la Demanderesse permettent difficilement d'obtenir un matériau avec des porosités de l'ordre de la dizaine de micromètres, ouvertes et fortement orientées.

A la connaissance de la Demanderesse, il n'existe donc pas aujourd'hui de procédé permettant une élaboration facile de pièces homogènes à porosité orientées de l'ordre de la dizaine de microns à partir de poudres métalliques de dimensions micrométriques et plus denses que le titane.

L'invention vient améliorer la situation.

Dans un mode de réalisation, le matériau métallique fritté présentant une structure lamellaire comprend au moins une partie ferromagnétique ou ferrimagnétique
. Le matériau est pourvu de porosités orientées débouchantes de dimension comprise entre 1 et 100 microns. Le matériau présente une densité variant de moins de 20 % d'un échantillon de 1 cm³ à l'autre pris dans une pièce monobloc réalisée dans ledit matériau. Ledit matériau présente d'excellentes propriétés résultant de leur grande surface spécifique. La partie magnétique est ferromagnétique ou ferrimagnétique.

On entend par métalllique un matériau composé d'atomes métalliques et éventuellement d'atomes non métalliques, les atomes étant liés entre eux par des liaisons métalliques En général, un matériau métallique comprend au moins 50% atomique de métal.

Dans un mode de réalisation, le matériau comprend une partie non magnétique en proportion volumique inférieure ou égale à 50 %. Les deux poudres - magnétique et non magnétique - peuvent être co-malaxées au préalable pour que les poudres magnétiques puissent entraîner les poudres non magnétiques en présence du champ magnétique. La partie magnétique est alors suffisante pour obtenir un alignement de la poudre devant être frittée selon des lignes de champs magnétiques.

Dans un mode de réalisation, la partie non magnétique comprend au moins un parmi : aluminium, niobium, titane, chrome, molybdène, manganèse, magnésium. Le titane et le niobium sont bio-compatibles donc les matériaux obtenus peuvent être utilisés pour fabriquer des prothèses médicales. Les poudres peuvent être mélangées indépendamment de leurs masses volumiques par co-broyage.

Dans un mode de réalisation, la partie magnétique est ferromagnétique.

Dans un mode de réalisation, la partie magnétique comprend au moins un parmi : fer, nickel, cobalt, alliage ferromagnétique, notamment acier ferromagnétique.

Dans un mode de réalisation, la partie magnétique comprend du nickel.

Dans un mode de réalisation, le matériau comprend une partie ferrimagnétique en proportion volumique inférieure ou égale à 50 %.

Dans un mode de réalisation, la partie magnétique comprend au moins un parmi : samarium-cobalt, néodyme-fer-bore.

Dans un mode de réalisation, les pores présentent un rapport d'aspect supérieur à 5. Dans un mode de réalisation, le procédé de fabrication d'un matériau métallique fritté comprend :
a. mélanger une poudre dont au moins une partie est ferromagnétique ou ferrimagnétique avec un solvant et verser le tout dans un moule,
b. appliquer un champ magnétique au mélange, le champ magnétique étant parallèle à +/- 10° près aux lignes de champ de gravitation pour faire passer dans le mélange moulé des lignes de champ magnétique provoquant le déplacement de la poudre jusqu'à affleurer une surface supérieure du mélange,
c. figer la structure en solidifiant la solution,
d. sublimer la solution solidifiée,
e. faire un traitement thermique de la pièce.

Ainsi, la poudre est orientée par le champ magnétique et va s'aligner selon les lignes de champ. L'ensemble est refroidi tout en conservant le champ magnétique jusqu'à ce que la structure soit figée par la solidification du solvant. Ainsi, on bénéficie d'étapes simples ne nécessitant pas d'équipements coûteux et permettant d'élaborer des pièces dont la structure interne est composée de lamelles présentant des porosités orientées dans le sens du champ magnétique, d'une taille de l'ordre de la dizaine de microns. En effet, sous l'action de l'aimant, les grains de poudre se comportent comme desdipôles magnétiques et s'alignent sur les lignes de champs. Les grains de poudre forment des zones où les lamelles ont la même orientation correspondant au champ magnétique local. Ces lamelles ont toutes une orientation préférentielle selon l'axe nord-sud de l'aimant et leur désorientation apporte une tenue mécanique à l'ensemble.

Le champ magnétique peut être obtenu par un aimant ou par une bobine. Le champ magnétique est alors facilement réglable par l'intensité électrique parcourant la bobine et le matériau obtenu est encore plus homogène qu'avec un aimant puisque les lignes de champ présentent un meilleur parallélisme.

On s'affranchit ainsi d'une étape de solidification unidirectionnelle puisque l'orientation des pores est due à la présence du champ magnétique. Le solvant est un moyen de figer la structure. Les défauts liés à la solidification directionnelle sont évités. Par exemple, dans les pièces conventionnelles, la première zone de solidification équiaxe forme une couche qui bouche les porosités orientées sur une surface et altère des propriétés de perméabilité. Or il est très difficile de reprendre un matériau poreux sans en boucher les pores. On s'affranchit également des défauts liés à une croissance de bras secondaires parallèlement au front de solidification susceptible de créer des fissures dans les lamelles.

Enfin, on évite l'inhomogénéité de la taille des pores le long de l'épaisseur de la pièce due à la faible conductivité thermique de la glace qui crée un gradient de vitesse de solidification. En libérant l'orientation des pores de la direction de solidification directionnelle, on obtient un matériau à porosités orientées de façon homogène dans la pièce.

Dans un mode de réalisation, la partie magnétique présente une granulométrie supérieure à 1 µm.

Dans un mode de réalisation, la poudre présente une granulométrie supérieure à 1 µm.

Dans un mode de réalisation, le mélange de poudre et de solvant comprend en outre un liant, le liant étant éliminé au frittage ou lors d'une étape de déliantage. On entend par déliantage une étape de retrait du liant. Le déliantage peut comprendre un palier à basse température d'environ 300-400°C éliminant le liant. Une telle température nettement inférieure à la température du frittage permet d'éviter la pollution chimique par des résidus carbonés lors du frittage à haute température de la pièce. La proportion de liant par rapport au solvant est préférablement comprise entre 1 et 5 % en masse.

Préférablement, la proportion de liant par rapport au solvant est comprise entre 1,5 et 4 % en masse. Le solvant est un moyen de figer la structure dans le champ magnétique grâce au liant avant le frittage de la pièce.

Dans un mode de réalisation, le solvant est choisi parmi : eau, camphène, TBA (alcool butylique tertiaire).

Dans un mode de réalisation, le solvant présente une viscosité dynamique comprise entre1 et 2 .10⁻³Pa.smesurée par un viscosimètre tel qu'un viscosimètre Brookfield selon ISO 2555 et ASTM D2196.

Dans un mode de réalisation, le champ magnétique est déterminé de manière que, la poudre étant constituée de grains, les grains s'aimantent et s'orientent dans le sens du champ tout en restant dans le mélange. Le champ magnétique est généré par un aimant permanent ou une bobine.

Dans un mode de réalisation, le champ magnétique est inférieur à 30mT, de préférence inférieur à 20 mT, plus préférentiellement compris entre 0, 5 et 3 mT pour de la poudre de nickel.

Dans un mode de réalisation, le solvant est sublimé par lyophilisation ou pompage à vide à basse température en-dessous du point triple du solvant.

Dans un mode de réalisation, la poudre présente un diamètre granulaire moyen compris entre 0,5 et 50 microns.

Dans un mode de réalisation, la poudre présente un diamètre granulaire inférieur à une valeur située dans la plage de 2 à 100 microns.

Dans un mode de réalisation, le frittage est effectué sous gaz inerte sous une pression de 0-0,25 bars pendant une durée comprise entre 30 et 180 minutes, à une température inférieure à 2/3 de la température de fusion du métal exprimée en kelvin.

Dans un mode de réalisation, la durée de frittage est comprise entre 40 et 90 minutes. Dans un mode de réalisation, la température de frittage est inférieure à 2/3 de la température de fusion du métal ayant le point de fusion le plus bas.

Dans un mode de réalisation, la température de frittage est inférieure à 2/3 de la température de fusion du métal exprimé en kelvin, diminuée de 100 K.

Dans un mode de réalisation, la température de frittage est inférieure à 2/3 de la température de fusion du métal ayant le point de fusion le plus bas, exprimée en kelvin, diminuée de 100 K.

Dans un mode de réalisation, le frittage est effectué avec une rampe de température inférieure ou égale à 20 K par minute, préférablement inférieure ou égale à 10 K par minute.

Dans un mode de réalisation, le frittage est suivi du dépôt d'un autre matériau en surface. L'autre matériau peut être déposé par cémentation, CVD, PVD, dépôt électrochimique ou électrolytique, imprégnation de poudre.

Dans un mode de réalisation, le mélange est coulé dans un matériau architecturé, obtenu par exemple par fabrication additive, ledit matériau architecturé apportant de la tenue mécanique au matériau poreux après frittage. Ledit matériau architecturé peut consister en une structure porteuse en métal dense par opposition au métal fritté. Ledit matériau architecturé peut consister en une grille 3D rigide. Ledit matériau architecturé peut consister en un ensemble de poteaux et de poutres, par exemple venu de fonderie. Le mélange vient autour du matériau architecturé et bénéficie de sa résistance mécanique tout en offrant ses propriétés intrinsèques.

Dans un mode de réalisation, la densité de la partie ferromagnétique est supérieure à la densité du titane.

La présente invention sera mieux comprise à la description détaillée de quelques modes de réalisation pris à titre d'exemples nullement limitatifs et illustrés par les dessins annexés :
- les figures 1 à 4 sont des extraits de coupe d'échantillons de matériaux pris au microscope optique,
- la figure 5 montre un exemple de montage pour le procédé, et
- la figure 6est une micrographie optique de matériau architecturé entouré de matériau métallique fritté.

Les matériaux métalliques à porosité orientée sont intéressants dans de nombreuses applications telles que la filtration ou la diffusion d'espèces chimiques. Les micropores peuvent également être efficacement infiltrés par un liquide, par exemple du lubrifiant dans des pièces dont on veut retarder l'usure mécanique. La grande surface spécifique des matériaux à porosités orientées en fait également de très bons choix pour des électrodes poreuses ou pour des applications de catalyse. Ces matériaux sont de très bons absorbeurs d'énergie thermique, mécanique ou électromagnétique ce qui les rend totalement intéressants pour des applications d'échangeur de chaleur, de protection contre les impacts ou les ondes de chocs, de boucliers pour les installations électriques contre les interférences dues à un rayonnement parasite, etc.

Par ailleurs, des matériaux à porosité contrôlée, judicieusement dimensionnés, peuvent reproduire de façon précise la morphologie anisotropique des os et donc leurs propriétés mécaniques. Il deviendrait possible d'améliorer la qualité et la durée de vie des prothèses biomédicales ainsi que leur ostéo-intégration.

Les phénomènes en jeu dans l'invention peuvent être expliqués dans un cas simplifié bidimensionnel où le champ magnétique appliqué est unidirectionnel, dans la direction verticale et où la poudre est sphérique.

La poudre est immergée dans le solvant : chaque particule est soumise à la gravité qui tend à la faire sédimenter ainsi qu'à la poussée d'Archimède qui tend à le faire flotter. La densité et la taille des grains de poudre métalliques et éventuellement non métalliques sont tels que la gravité l'emporte sur la poussée d'Archimède et la poudre coule au fond du moule.

On applique un champ magnétique *̅B̅*̅ à l'ensemble. Si ce champ est suffisamment important, progressivement chaque grain de poudre magnétique s'aimante dans la direction du champ magnétique *̅B̅*̅. Chaque grain de poudre magnétique se comporte localement comme un petit aimant. Par l'action de forces de répulsion et d'attraction magnétiques, les grains de poudre vont créer des chaînes dans le sens du champ magnétique *̅B̅*̅. Ce mouvement va être grandement facilité par la poussée d'Archimède exercée par le solvant.

Ces chapelets de grains de poudre vont monter jusqu'à l'interface solvant/air. La force engendrée par le champ magnétique *̅B̅*̅ tend à prolonger l'alignement des structures au-delà de cette interface en faisant sortir les grains de poudre du solvant. Cependant, cette traversée de l'interface coûterait de l'énergie :
- l'absence de poussée d'Archimède rend le mouvement des grains de poudre beaucoup plus difficile dans l'air,
- la tension de surface air/eau tend à empêcher la traversée des grains de poudre.

On a donc un antagonisme entre :
- les forces visant à faire traverser l'interface : la force attractive de l'aimant et les forces répulsives entre chapelets de poudre voisins,
- les forces visant à confiner la poudre sous l'interface solvant/air citées précédemment.

On applique un champ magnétique *̅B̅*̅ dans une fourchette précise pour créer le matériau final : suffisamment fort pour aimanter la poudre et créer l'alignement des particules, mais sans dépasser la valeur pour laquelle la poudre traverse l'interface.

Afin d'obtenir le matériau final, le solvant est ensuite solidifié puis sublimé, et la pièce est frittée à haute température.

Dans un système réel en trois dimensions, on obtient des lamelles de poudre et non des colonnes. Ceci s'explique par les forces répulsives et attractives qui tendraient à former des structures bidimensionnelles. Si les lignes de champ magnétique ne sont pas parallèles dans l'espace considéré, comme c'est le cas si on utilise un aimant classique, on observe des zones où les lamelles ont la même orientation correspondant au champ magnétique local. Ces lamelles ont toutes une orientation préférentielle selon l'axe principal de l'aimant. Leur désorientation apporte une tenue mécanique à l'ensemble. En effet, si toutes les lamelles de l'échantillon étaient parfaitement parallèles, l'ensemble serait extrêmement fragile lorsque sollicité perpendiculairement aux lamelles. La désorientation partielle des lamelles améliore la tenue aux sollicitations transversales.

L'interface solvant/air confine la poudre. Le volume de la pièce finale est donc facilement contrôlable puisqu'il est égal au volume de solvant. Cela permet aussi de faire varier précisément la porosité de la pièce. Tous paramètres égaux par ailleurs, s'il y a plus de solvant, l'espace entre les chaînes de poudre sera plus grand et la pièce finale sera donc plus poreuse.

La microstructure est composée de lamelles présentant des porosités ouvertes orientées dans le sens du champ magnétique, d'une taille de l'ordre de la dizaine de microns. Le choix des paramètres permet des dimensions de pores entre 1 et 100 µm et une homogénéité du matériau obtenu telle que la densité varie de moins de 20% d'un échantillon de 1 cm³ à l'autre pris dans une pièce monobloc réalisée dans ledit matériau, notamment une pièce de volume de 4 cm³.

Une partie non magnétique est possible en proportion volumique inférieure ou égale à 50%. La partie non magnétique comprend au moins un parmi : aluminium, niobium, titane, chrome, molybdène, manganèse, magnésium.

Une partie ferrimagnétique est également possible en proportion volumique inférieure ou égale à 50%.

Dans le cas général, la partie magnétique est ferromagnétique et comprend au moins un parmi : fer, nickel, cobalt, alliage ferromagnétique, notamment acier ferromagnétique.

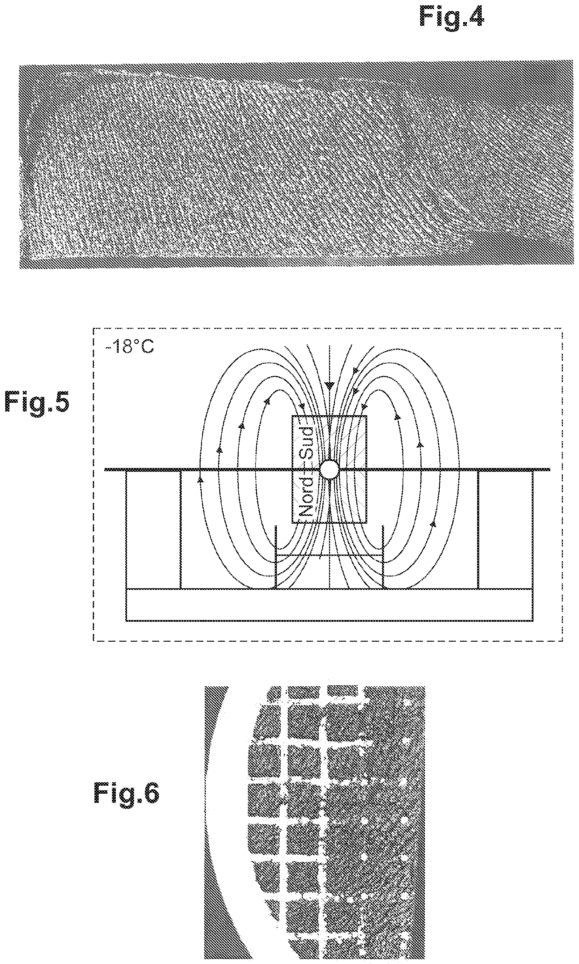

Dans un premier essai, a été fabriqué un pion cylindrique de nickel à porosités orientées. Une solution aqueuse contenant 3 % massique de liant organique, ici de l'alcool polyvinylique (PVA), est préparée. Puis 7,5g de poudre de nickel pur, d'un diamètre inférieur à 3 µm, sont mélangés à 4 ml de solution aqueuse. L'ensemble est versé dans un plot en Téflon de 3 cm de diamètre reposant sur une plaque métallique puis un aimant en ferrite est placé quelques centimètres au-dessus du plot à l'aide d'une barrette amagnétique fixée sur des supports latéraux, voir figure 5. Le champ moyen au niveau de la solution aqueuse chargée de poudre de nickel est de l'ordre de 2mT. L'aimant est de forme allongée et disposé de façon à avoir des lignes de champ perpendiculaires à la surface du solvant. Les lignes de champ sont verticales pour une partie de la solution et arrondies pour d'autres parties de la solution. L'ensemble du montage est alors placé dans une enceinte de refroidissement réglée à une température inférieure à la température de solidification de la solution aqueuse, par exemple - 18°C, jusqu'à solidification complète de l'eau.

On prélève ensuite la solution solidifiée ainsi que la plaque métallique la supportant et on la monte sur une plaque réfrigérante réglée à - 10°C. La plaque est ensuite recouverte d'un couvercle adapté scellé, et reliée à une pompe à vide. La pompe à vide permet d'atteindre un vide de l'ordre de quelques dixièmes de Pascal. La pression est contrôlée par un capteur de pression. Au bout de 16h, l'eau est intégralement sublimée. En outre, un piège à azote liquide permet de recondenser la vapeur d'eau afin de protéger la pompe.

Une fois la sublimation de l'eau réalisée, on dispose d'une pièce à vert avec des grains de poudre orientés dont la tenue est assurée temporairement par le liant.

La pièce à vert est soumise à un traitement thermique de 60 minutes à 900°C sous flux d'argon pour obtenir la pièce frittée finale qui présente un diamètre de 2,5 cm soit un retrait de 17 %. La pression est de 0,25 bar. La montée en température est de 10 K/minute. La descente en température est de 10 K/minute.

Il a été constaté que la surface libre obtenue est relativement rugueuse. Pour obtenir des surfaces planes et parallèles, les deux faces d'extrémité peuvent être polies. Ceci créé une couche dense superficielle. La couche superficielle peut être éliminée en plongeant la pièce dans une solution d'acide nitrique dilué à 50 %. Cette étape peut également être évitée en utilisant un moule pour lequel la surface libre ne correspond pas à une surface d'intérêt. La pièce frittée présente des lamelles de nickel entremêlées avec une taille de pore moyen de 50 µm. Les pores sont débouchants. La perméabilité de Darcy de l'échantillon est de 10⁻¹² m². Le traitement thermique a une influence sur la densité des lamelles et sur le retrait. L'alignement des pores sur les lignes de champ magnétique est conservé. La densité est homogène.

Par ailleurs, la demanderesse a fabriqué d'autres échantillons selon le tableau ci-dessous avec de la poudre de nickel pur de diamètre moyen 3µm :

| N° | Masse de poudre (g) | Volume de la solution (ml) | % en masse de PVA | Durée de la congélation (jours) | Durée du frittage (h) | Rampe de montée et descente du four(°C/min) | Température du frittage (°C) | Porosité de la pièce (%) |
|---|---|---|---|---|---|---|---|---|
| 1 | 7,5 | 4 | 2 | 2 | 1 | 10 | 900 | 72 |
| 2 | 7,5 | 3 | 2 | 2 | 1 | 10 | 900 | 64 |
| 3 | 7,5 | 5 | 2 | 2 | 1 | 10 | 900 | 74 |
| 4 | 7,5 | 5,5 | 3 | 2 | 1 | 10 | 900 | 75 |

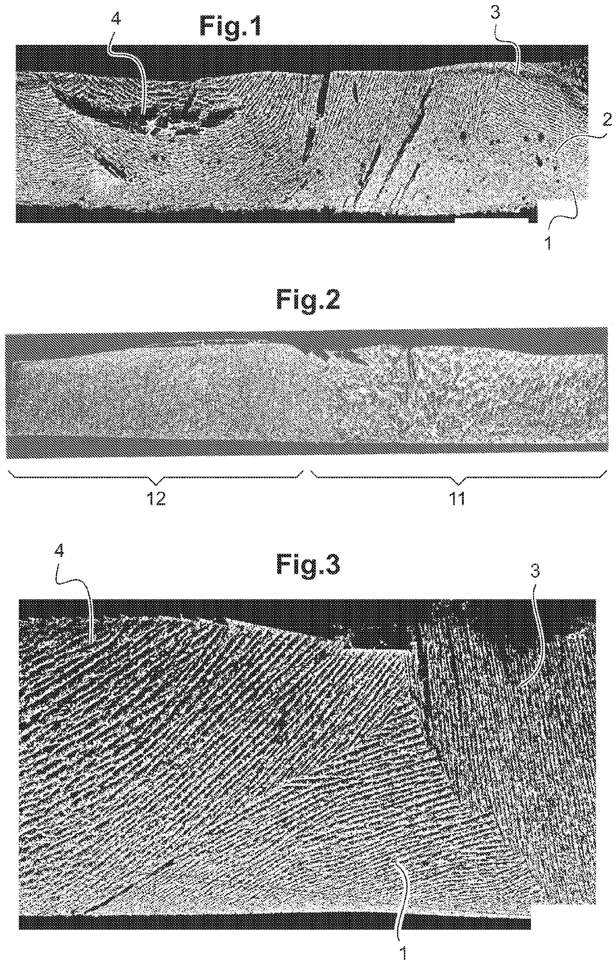

La figure 1 montre un aspect de l'échantillon n° 1 avec une zone inférieure 1 présentant zone légèrement moins poreuse sur une faible hauteur de quelques % de la hauteur de l'échantillon.

La zone d'intérêt 3 présente une orientation des lamelles de nickel bien parallèle à l'axe nord/sud de l'aimant. Les lamelles sont donc relativement proches de la verticale à proximité de la zone périphérique 2 et de plus en plus inclinées en se rapprochant de la zone centrale 4 située sous l'aimant. La zone centrale 4 présente une partie avec des hétérogénéités. L'espace inter-lamellaire moyen est de 18,2 µm +/- 2. Le taux de porosité est élevé à 72 %.

De l'observation de la figure 1, la Demanderesse déduit l'intérêt de mettre en œuvre un champ magnétique à lignes de champ parallèles sur toute la zone de l'échantillon, par exemple au moyen d'un montage d'aimants ou d'une bobine électromagnétique. La sédimentation présente en zone inférieure 1 peut également au besoin être diminuée par la mise en œuvre d'une sonotrode ou d'un bain à ultrason.

L'échantillon n°2 illustré en figure 2 présente une zone 11 à porosités orientées dans un plan perpendiculaire au plan d'observation. Cette zone a manqué de solvant limitant l'aptitude à l'orientation selon les lignes de champ. L'échantillon présente une zone d'intérêt 12 à porosités orientées de manière relativement parallèle. L'effet de sédimentation en zone inférieure est plus faible que sur l'échantillon 1. Les lamelles sont serrées et la densité obtenue élevée ce qui correspond à une porosité plus faible que pour l'échantillon n°1. L'effet de la diminution de la quantité de solution entre l'échantillon n°1 et l'échantillon n°2 est de présenter des espaces inter-lamellaires plus petits. L'espace inter-lamellaire moyen est de 10 µm +/-6. Le taux de porosité est élevé à 64 %.

L'échantillon n°3 présente un aspect plus proche de l'échantillon n°1 avec une zone inférieure 1 présentant une légère sédimentation de la poudre antérieure à la sublimation, une zone centrale 4 présentant des porosités parallèles par zones L'espace inter-lamellaire moyen est de 31 µm +/-4. Le taux de porosité est élevé à 74 %. L'échantillon présente des aspérités.

La porosité est plus élevée que pour les échantillons n°1 et n°2. On observe la présence de zones 3 et 4 où les lamelles sont parallèles entre elles.

Dans le mode de réalisation de la figure 4, la sédimentation en bas de l'échantillon est faible. L'espace inter-lamellaire est plus grand que pour l'échantillon n°3. Les porosités sont orientées quasiment verticalement. Des aspérités de surface sont présentes. L'espace inter-lamellaire moyen est de 41µm+/-7. Le taux de porosité est très élevé à 75 %.

La comparaison entre les échantillons n°1 à n°4 permet d'étudier l'influence du paramètre de volume de la solution. Une augmentation du volume de la solution se traduit par une augmentation du taux de porosité et une augmentation de l'espace inter-lamellaire.

Enfin, il est préférable d'appliquer le champ magnétique avant la mise en place dans l'enceinte de refroidissement afin de permettre aux poudres de se placer selon les lignes de champ magnétique avant la solidification de la solution.

Sur la figure 6 a été illustré un exemple de matériau métallique fritté formé autour d'une structure métallique de densité nominale. On entend ici par densité nominale la densité d'un métal ou alliage métallique massif microscopiquement, par exemple coulé ou usiné. La structure métallique est ici une grille à maille carrée entouré d'un anneau. La structure métallique présente des propriétés mécaniques supérieures aux propriétés mécaniques du matériau métallique fritté. La structure métallique est obtenue par coulée ou par fabrication additive. Le matériau métallique fritté remplit les trous carrés de la grille.En pratique, on prévoit soit de conserver libre la surface supérieure de la grille, soit de la recouvrir par le matériau métallique fritté. Le matériau métallique fritté est obtenu en mettant en œuvre 7,5 g de poudre de Ni, 5 ml de solution, 2% de PVA avec un frittage de 1 heure à 900°C, les autres paramètres étant identiques à ceux de l'essai n°3. L'espace interlamellaire obtenu est de 37µm +/- 2. Le matériau métallique fritté est compatible avec une structure mécaniquement résistante.

## Revendications

1. Matériau métallique fritté présentant une structure lamellaire et comprenant au moins une partie ferromagnétique ou ferrimagnétique, ledit matériau présentant des porosités orientées débouchantes de dimension comprise entre 1 et 100 µm, **caractérisé par** une densité variant de moins de 20% d'un échantillon de 1 cm³ à un autre pris dans une pièce monobloc réalisée dans ledit matériau.

2. Matériau selon la revendication 1, comprenant au moins une partie non magnétique en proportion volumique inférieure ou égale à 50% et, optionnellement, une partie ferrimagnétique en proportion volumique inférieure ou égale à 50%.

3. Matériau selon la revendication 2, dans lequel la partie non magnétique comprend au moins un parmi : aluminium, niobium, titane, chrome, molybdène, manganèse, magnésium.

4. Matériau selon l'une des revendications précédentes, dans lequel la partie ferromagnétique ou ferrimagnétique est ferromagnétique et comprend au moins un parmi : fer, nickel, cobalt, alliage ferromagnétique, notamment acier ferromagnétique.

5. Procédé de fabrication d'un matériau métallique fritté comprenant :
- Fournir un mélange de poudre métallique et de solvant, la poudre comprenant une partie ferromagnétique ou ferrimagnétique,
- Couler le mélange dans un moule,
- Appliquer un champ magnétique parallèle à +/- 10° près aux lignes de champ de gravitation pour faire passer dans le mélange moulé des lignes de champ magnétique provoquant le déplacement de la poudre jusqu'à affleurer une surface supérieure du mélange,
- Refroidir le mélange moulé à une température inférieure à la température de solidification du solvant,
- Sublimer le solvant solidifié,
- Fritter la poudre pour obtenir le matériau métallique fritté, les pores du matériau étant alignés sur les lignes de champ magnétique, débouchant et de dimension comprise entre 1 et 100 µm, le matériau métallique fritté présentant une densité variant de moins de 20% d'un échantillon de 1 cm³ à un autre pris dans une pièce monobloc réalisée dans ledit matériau.

6. Procédé selon la revendication 5, dans lequel le mélange de poudre et de solvant comprend en outre un liant, préférablement de l'alcool polyvinylique, le liant étant éliminé au frittage, la proportion de liant par rapport au solvant étant préférablement compris entre 1 et 5% en masse, préférablement entre 1,5 et 4%.

7. Procédé selon la revendication 5 ou 6, dans lequel le solvant est choisi parmi : eau, camphène, TBA Alcool Butylique Tertiaire ou Méthyl-2 propanol-2.

8. Procédé selon l'une des revendications 5 à 7, dans lequel le champ magnétique est déterminé de manière que, la poudre étant constituée de grains, les grains s'aimantent et s'orientent dans le sens du champ tout en restant dans le mélange, le champ magnétique étant généré par un aimant permanent ou une bobine.

9. Procédé selon l'une des revendications 5 à 8, dans lequel le champ magnétique est inférieur à 30 mT, de préférence inférieur à 20 mT, plus préférentiellement pour de la poudre de nickel compris entre 0,5 et 3 mT.

10. Procédé selon l'une des revendications 5 à 9, dans lequel le solvant est sublimé par lyophilisation ou pompage à vide à basse température en dessous du point triple du solvant.

11. Procédé selon l'une des revendications 5 à 10, dans lequel le frittage est effectué sous gaz inerte sous une pression de 0 à 0,25 bar pendant une durée comprise entre 30 et 180 minutes, préférablement entre 40 et 90 minutes, à une température inférieure à 2/3 de la température de fusion du métal - la cas échéant du métal ayant le point de fusion le plus bas - exprimée en Kelvin, préférablement inférieure à 2/3 de la température de fusion du métal - la cas échéant du métal ayant le point de fusion le plus bas - exprimée en Kelvin, diminuée de 100 K.

12. Procédé selon l'une des revendications 5 à 11, dans lequel le frittage est effectué avec une rampe de montée et descente en température inférieure ou égale à 20 K/minute, préférablement inférieure ou égale à 10 K/minute.

13. Procédé selon l'une des revendications 5 à 12, dans lequel le frittage est suivi par un dépôt d'un autre matériau en surface, par cémentation, CVD, PVD, dépôt électrochimique ou électrolytique, imprégnation de poudre.

14. Procédé selon l'une des revendications 5 à 13, dans lequel le mélange est coulé dans une structure architecturée, obtenue par exemple par fabrication additive ou par fonderie, pour apporter de la tenue mécanique.

## Patentansprüche

1. Gesintertes metallisches Material, das eine Lamellenstruktur aufweist und mindestens einen ferromagnetischen oder ferrimagnetischen Teil umfasst, wobei das Material durchgehende gerichtete Poren mit einer Größe zwischen 1 und 100 µm aufweist, **gekennzeichnet durch** eine Dichte, die von einer 1 cm3 großen Probe zu einer anderen, die in einem aus dem Material hergestellten einteiligen Teil genommen wurde, um weniger als 20 % variiert.

2. Material nach Anspruch 1, das mindestens einen nichtmagnetischen Teil mit einem Volumenanteil von 50 % oder weniger und optional einen ferrimagnetischen Teil mit einem Volumenanteil von 50 % oder weniger enthält.

3. Material nach Anspruch 2, wobei der nichtmagnetische Teil mindestens eines der folgenden Elemente umfasst: Aluminium, Niob, Titan, Chrom, Molybdän, Mangan, Magnesium.

4. Material nach einem der vorhergehenden Ansprüche, wobei der ferromagnetische oder ferrimagnetische Teil ferromagnetisch ist und mindestens eines von: Eisen, Nickel, Kobalt, ferromagnetische Legierung, insbesondere ferromagnetischer Stahl, umfasst.

5. Verfahren zur Herstellung eines gesinterten metallischen Materials, umfassend :
- Bereitstellen einer Mischung aus Metallpulver und Lösungsmittel, wobei das Pulver einen ferromagnetischen oder ferrimagnetischen Anteil umfasst,
- Die Mischung in eine Form gießen,
- Anlegen eines Magnetfelds, das innerhalb von +/- 10° parallel zu den Gravitationsfeldlinien verläuft, um in der geformten Mischung Magnetfeldlinien zu erzeugen, die eine Bewegung des Pulvers bewirken, bis es mit einer oberen Oberfläche der Mischung bündig ist,
- Kühlen Sie die geformte Mischung auf eine Temperatur unterhalb der Verfestigungstemperatur des Lösungsmittels ab,
- Sublimieren Sie das erstarrte Lösungsmittel,
- Sintern des Pulvers, um das gesinterte metallische Material zu erhalten, wobei die Poren des Materials auf die Magnetfeldlinien ausgerichtet sind, durchgängig sind und eine Größe zwischen 1 und 100 µm haben, wobei das gesinterte metallische Material eine Dichte aufweist, die von einer 1 cm3 großen Probe zu einer anderen, die aus einem einteiligen Teil aus diesem Material entnommen wurde, um weniger als 20 % schwankt.

6. Verfahren nach Anspruch 5, bei dem die Mischung aus Pulver und Lösungsmittel zusätzlich ein Bindemittel, vorzugsweise Polyvinylalkohol, umfasst, wobei das Bindemittel beim Sintern entfernt wird und das Verhältnis von Bindemittel zu Lösungsmittel vorzugsweise zwischen 1 und 5 Massenprozent, vorzugsweise zwischen 1,5 und 4 Prozent, liegt.

7. Verfahren nach Anspruch 5 oder 6, wobei das Lösungsmittel ausgewählt ist aus: Wasser, Camphen, TBA Tertiärer Butylalkohol oder 2-Methyl-2-propanol.

8. Verfahren nach einem der Ansprüche 5 bis 7, wobei das Magnetfeld so bestimmt wird, dass, da das Pulver aus Körnern besteht, die Körner sich magnetisieren und sich in Richtung des Feldes ausrichten, während sie in der Mischung bleiben, wobei das Magnetfeld von einem Permanentmagneten oder einer Spule erzeugt wird.

9. Verfahren nach einem der Ansprüche 5 bis 8, bei dem das Magnetfeld weniger als 30 mT, vorzugsweise weniger als 20 mT, besonders bevorzugt für Nickelpulver zwischen 0,5 und 3 mT beträgt.

10. Verfahren nach einem der Ansprüche 5 bis 9, bei dem das Lösungsmittel durch Gefriertrocknung oder Vakuumpumpen bei niedriger Temperatur unterhalb des Tripelpunkts des Lösungsmittels sublimiert wird.

11. Verfahren nach einem der Ansprüche 5 bis 10, wobei das Sintern unter Inertgas bei einem Druck von 0 bis 0,25 bar über einen Zeitraum von 30 bis 180 Minuten, vorzugsweise 40 bis 90 Minuten, bei einer Temperatur von weniger als 2/3 der Schmelztemperatur des Metalls - gegebenenfalls des Metalls mit dem niedrigsten Schmelzpunkt -, ausgedrückt in Kelvin, durchgeführt wird, vorzugsweise weniger als 2/3 der Schmelztemperatur des Metalls - gegebenenfalls des Metalls mit dem niedrigsten Schmelzpunkt -, ausgedrückt in Kelvin, vermindert um 100 K.

12. Verfahren nach einem der Ansprüche 5 bis 11, bei dem das Sintern mit einer Temperaturanstiegs- und -abfallrampe von weniger als oder gleich 20 K/Minute, vorzugsweise weniger als oder gleich 10 K/Minute, durchgeführt wird.

13. Verfahren nach einem der Ansprüche 5 bis 12, bei dem auf das Sintern eine Abscheidung eines anderen Materials auf der Oberfläche folgt, durch Aufkohlung, CVD, PVD, elektrochemische oder elektrolytische Abscheidung, Pulverimprägnierung.

14. Verfahren nach einem der Ansprüche 5 bis 13, bei dem die Mischung in eine architektonische Struktur gegossen wird, die z. B. durch additive Fertigung oder Gießen erhalten wird, um mechanischen Halt zu verleihen.

## Claims

1. A sintered metallic material having a lamellar structure and comprising at least one ferromagnetic or ferrimagnetic portion, said material having open-ended oriented porosities of dimension of between 1 and 100 µm, **characterized by** a density varying by less than 20% from one 1 cm³ sample to another taken from a single-piece part made from said material.

2. The material as claimed in claim 1, comprising at least one non-magnetic portion in a volume proportion of less than or equal to 50% and optionally a ferrimagnetic part in a volume proportion of less than or equal to 50%.

3. The material as claimed in claim 2, wherein the non-magnetic portion comprises at least one from: aluminum, niobium, titanium, chromium, molybdenum, manganese, magnesium.

4. The material as claimed in one of the preceding claims, wherein the ferromagnetic or ferrimagnetic portion is ferromagnetic and comprises at least one from: iron, nickel, cobalt, ferromagnetic alloy, especially ferromagnetic steel.

5. A process for manufacturing a sintered metallic material, comprising:
- Providing a mixture of metallic powder and of solvent, the powder comprising a ferromagnetic or ferrimagnetic portion,
- Casting the mixture into a mold,
- Applying a magnetic field parallel to within +/- 10° to the gravitational field lines in order to cause the magnetic field lines to pass into the molded mixture, causing the displacement of the powder until it is flush with an upper surface of the mixture,
- Cooling the molded mixture to a temperature below the solidification temperature of the solvent,
- Sublimating the solidified solvent,
- Sintering the powder to obtain the sintered metallic material, the pores of the material being aligned along the magnetic field lines, being open-ended and being of dimension of between 1 and 100 µm, the sintered metallic material having a density varying by less than 20% from one 1 cm³ sample to another, taken from a single-piece part made from said material.

6. The process as claimed in claim 5, wherein the mixture of powder and solvent also comprises a binder, preferably polyvinyl alcohol, the binder being eliminated during sintering, the proportion of binder relative to the solvent being preferably between 1 and 5% by weight, preferably between 1.5 and 4%.

7. The process as claimed in claim 5 or 6, wherein the solvent is chosen from: water, camphene, TBA (tert-butyl alcohol or 2-methylpropan-2-ol).

8. The process as claimed in one of claims 5 to 7, wherein the magnetic field is determined such that, the powder consisting of grains, the grains become magnetized and oriented in the direction of the field while remaining in the mixture, the magnetic field being generated by a permanent magnet or a coil.

9. The process as claimed in one of claims 5 to 8, wherein the magnetic field is less than 30 mT, preferably less than 20 mT, more preferentially for the nickel powder, between 0.5 and 3 mT.

10. The process as claimed in one of claims 5 to 9, wherein the solvent is sublimated by lyophilization or vacuum pumping at low temperature, below the triple point of the solvent.

11. The process as claimed in one of claims 5 to 10, wherein the sintering is carried out under inert gas under a pressure of 0 to 0.25 bar for a duration of between 30 and 180 minutes, preferably between 40 and 90 minutes, at a temperature less than 2/3 of the melting point of the metal - where appropriate, of the metal having the lowest melting point - expressed in Kelvin, preferably less than 2/3 of the melting point of the metal - where appropriate, of the metal having the lowest melting point - expressed in Kelvin, decreased by 100 K.

12. The process as claimed in one of claims 5 to 11, wherein the sintering is carried out with a temperature rise and fall ramp of less than or equal to 20 K/minute, preferably less than or equal to 10 K/minute.

13. The process as claimed in one of claims 5 to 12, wherein the sintering is followed by a deposition of another material on the surface, by carburization, CVD, PVD, electrochemical or electrolytic deposition, powder impregnation.

14. The process as claimed in one of claims 5 to 13, wherein the mixture is cast in an organized structure, obtained for example by additive manufacturing or by foundry, to provide mechanical strength.
